# EUROPÄISCHE PATENTSCHRIFT

(11) **EP 2 461 221 B1**
(45) Veröffentlichungstag und Bekanntmachung des Hinweises auf die Patenterteilung: **06.03.2019**
(21) Anmeldenummer: 11189768.2
(22) Anmeldetag: 18.11.2011
(51) Int. Cl.: G05B 19/042

(54) **Steuergerät mit einem zur Verarbeitung von Signalen unterschiedlicher Sensortypen eingerichteten Eingaben**
Control device with an input equipped for processing signals of various sensor types
Appareil de commande avec des entrées destinées au traitement de signaux provenant de types de capteurs différents

(30) Priorität: 02.12.2010 DE 102010053304
(43) Veröffentlichungstag der Anmeldung: 06.06.2012
(73) Patentinhaber: Automotive Lighting Reutlingen GmbH, 72762 Reutlingen (DE)
(72) Erfinder: Zimmermann, Christian, 72108 Rottenburg (DE)
(74) Vertreter: DREISS Patentanwälte PartG mbB

(56) Entgegenhaltungen:
- EP-A2- 2 101 159
- US-A- 5 982 290
- US-A1- 2007 063 197
- US-A1- 2009 187 306
- "AN2710 Application note Safe GPIO port configuration in STR7xx devices Contents", , 1. Februar 2008 (2008-02-01), XP055120474, Gefunden im Internet: URL:http://www.st.com/st-web-ui/static/act ive/en/resource/technical/document/applica tion_note/CD00185009.pdf [gefunden am 2014-05-27]
- E. Jacobsen: "Creating a PWM Output Sensor Using a Field-Programmable Analog Array", Sensormag , 1 January 2009 (2009-01-01), Retrieved from the Internet: URL:http://archives.sensorsmag.com/article s/0598/pwm0598/main.shtml [retrieved on 2016-07-26]

## Beschreibung

Die vorliegende Erfindung betrifft ein zur Verwendung in einem Kraftfahrzeug eingerichtetes Steuergerät nach dem Oberbegriff des Anspruchs 1. Darüber hinaus betrifft die Erfindung ein Verfahren nach dem Oberbegriff des unabhängigen Verfahrensanspruchs 8.

Ein solches Verfahren ist jeweils aus der US 2009/0187306 A1 bekannt.

Die Veröffentlichung "AN2710 Application note Safe GPIO port configuration in STR7xx devices", 1. Februar 2008, XP05512047, zeigt durch firm ware als Input, Output, alternate function, output open drain, output push-pull, bidirectional week push-pull und high impedance sowie als analog input port programmierbare Ports. Dabei werden konfigurierbare pull-up und pull-down-Eingangsschaltungen verwendet.

Die EP 2 101 159 A2 zeigt eine analoge und digitale sensoren-adaptierbare Sensorschnittstelle.

Die US 2007/0063197 A1 zeigt eine konfigurierbare Eingangsschaltung, die an verschiedene Sensoren anpassbar ist. Die Eingangsschaltung nutzt pull-up and pull-down-Schaltungen.

Die US 5,982,290 betrifft eine Füllstandserkennung, die sowohl mit einem Analog-Füllstandsensor als auch mit einem PWM-Füllstandsensor arbeiten kann.

Steuergeräte der eingangs genannten Art verarbeiten Sensorsignale und erzeugen daraus Stellgrößen, mit denen Stellglieder des Kraftfahrzeugs angesteuert werden, um das Verhalten des Kraftfahrzeugs und/oder von Teilen des Kraftfahrzeugs im Betrieb zu beeinflussen. Dadurch sollen zum Beispiel Betriebskenngrößen des Kraftfahrzeugs in einem erlaubten Rahmen gehalten werden. Die Betriebskenngrößen bilden sich dabei in physikalischen Größen ab, die von Sensoren erfasst und in elektrische Sensorsignale umgewandelt werden. Zur Übergabe der elektrischen Sensorsignale an das Steuergerät sind Schnittstellen erforderlich, die von Sensoren bereitgesellte Sensorsignale in Signale umwandeln, die vom Steuergerät verarbeitet werden können. Unterschiedliche Sensoren erfordern dabei unterschiedliche Schnittstellen. So sind zum Beispiel analoge Schnittstellen, Schnittstellen für PWM-Signale (PWM = Pulsweitenmodulation), Frequenzschnittstellen und Busschnittstellen bekannt.

Die Schnittstellen sind in der Regel in das Steuergerät integriert und weisen einen Eingangsanschluss, eine Eingangsschaltung und einen Eingangskanal auf.

Je nachdem, welcher Sensortyp an den Eingangsanschluss anzuschließen ist, unterscheiden sich die Schnittstellen sowohl mit Blick auf ihre Eingangsschaltung als auch mit Blick auf den Eingangskanal.

Mit Blick auf die Eingangsschaltung unterscheiden sich Eingänge von Steuergeräten zum Beispiel darin, ob das definierte Potenzial einen vergleichsweise größeren Wert (zum Beispiel fünf Volt) oder einen vergleichsweise kleineren Wert (zum Beispiel null Volt) besitzt. In beiden Fällen dient das definierte Potenzial zur Festlegung eines Referenzpotenzials, mit dem zum Beispiel Fehlerzustände detektiert werden können. Die Anbindung an das vergleichsweise tiefere Potenzial erfolgt dann, wenn der Sensor eine Stromquelle darstellt. Dies ist in der Regel bei einem Analogsensor der Fall. Die Anbindung an das vergleichsweise höhere Potenzial erfolgt dann, wenn der Sensor eine Stromsenke darstellt. Dies ist in der Regel bei einem PWM-Sensor der Fall.

Mit Blick auf die Eingangskanäle ergeben sich zum Beispiel folgende Unterschiede: Zur Auswertung eines analogen Signals wird zum Beispiel ein Eingangskanal mit einem ADC, also einem Analog-Digital-Wandler, benötigt. Zur Auswertung eines PWM-Signals wird dagegen ein Eingangskanal mit einem Digital-Port benötigt, der im Idealfall eine Capture/Compare-Funktion besitzt.

Im heute üblichen Normalfall entspricht die Zahl der (Sensor)-Eingänge eines Kraftfahrzeug-Steuergerätes genau der Anzahl von Sensoren, deren Signale von diesem Steuergerät auszuwerten sind. Diese Zahl kann bereits innerhalb einer Fahrzeugbaureihe je nach Ausstattung der einzelnen Fahrzeuge unterschiedlich sein. So sind zum Beispiel viele Kraftfahrzeuge serienmäßig mit Halogen-Glühlampen in ihren Scheinwerfern ausgerüstet. Fahrzeuge derselben Baureihe können aber häufig auch auf Wunsch mit Gasentladungslampen ausgerüstet werden, die größere Lichtströme bereitstellen. Um eine Blendung anderer Verkehrsteilnehmer zu vermeiden, ist bei Fahrzeugen mit Gasentladungslampen meist eine Leuchtweitenregelung vorgesehen. Dies ergibt sich aus gesetzlichen Vorschriften, die eine solche Leuchtweitenregelung für Scheinwerfer fordern, die einen Lichtstrom von mehr als 2000 Lumen liefern. In der Regel nutzt eine solche Leuchtweitenregelung Signale von Neigungssensoren, die zum Beispiel im Fahrwerk des Kraftfahrzeugs angeordnet sind und die die Neigung der Fahrzeugkarosserie erfassen. Diese Sensoren sind bei Fahrzeugen der gleichen Baureihe, die mit Halogen-Glühlampen ausgerüstet sind, häufig nicht vorhanden.

Aus Kostengründen wird zunehmend versucht, Komponenten, zu denen auch Steuergeräte gehören, zu standardisieren. Das Ziel einer solchen Standardisierung ist, dass die standardisierte Komponente innerhalb einer Fahrzeugbaureihe möglichst breit verwendet werden kann, ohne dass Ausstattungsunterschiede eine unterschiedliche Hardware der Komponenten erforderlich machen. Dies gilt analog auch über verschiedene Fahrzeugbaureihen hinweg. Dabei können bestimmte Randbedingungen dazu führen, dass für ein und dieselbe Funktion, zum Beispiel für die automatische Leuchtweitenregelung, fahrzeugabhängig unterschiedliche Sensortypen und eine unterschiedliche Anzahl von Sensoren verwendet werden. Für die automatische Leuchtweitenregelung sind zum Beispiel Lösungen bekannt, die einen, zwei oder drei Sensoren verwenden. Je nach Ausgestaltung sind diese Sensoren dazu eingerichtet, analoge Ausgangssignale zu liefern, während andere Sensoren dazu eingerichtet sind, PWM-Signale bereitzustellen.

Aus den möglichen Unterschieden in der Zahl und im Typ der an ein Steuergerät anzuschließenden Sensoren ergibt sich eine Vielzahl unterschiedlicher Kombinationen von Eingangssignalen unterschiedlicher Art. Ein Steuergerät, das diese unterschiedlichen Kombinationen verarbeiten kann, muss in Bezug auf seine Hardware und seine Software ausreichend flexibel sein.

Im Rahmen des Beispiels der Leuchtweitenregelung muss es zum Beispiel möglich sein, sowohl Analog-Sensoren als auch PWM-Sensoren anzuschließen. In diesem Zusammenhang wird ein Steuergerät als bekannt vorausgesetzt, das für einen Eingang zwei Eingangskanäle aufweist. Für den Einsatz in einem bestimmten Fahrzeug wird das Steuergerät dann mit einer Eingangsschaltung bestückt, die einen der beiden Eingangskanäle mit dem Eingangsanschluss dieses Eingangs verbindet. Damit können Steuergeräte eines Typs zwar an verschiedene Fahrzeuge angepasst werden, allerdings ist pro Variante eine Steuergerät-Variante erforderlich. Die verschiedenen Steuergerät-Varianten unterscheiden sich voneinander in der Hardware ihrer Eingangsschaltungen.

Die Bestückung von Steuergeräten mit Eingangsschaltungen, die für verschiedene Fahrzeugvarianten individualisiert sind, ist aufwändig und sie erschwert auch die Bereitstellung von Ersatzteilen. Beides treibt die jeweiligen Kosten, sei es für die Herstellung, sei es für die Ersatzteilhaltung, in die Höhe. Auch die Zufuhr von Steuergeräten zum Fahrzeug bei dessen Herstellung wird komplizierter, da verschiedene Fahrzeugvarianten häufig auf der gleichen Produktionslinie gefertigt werden und daher sichergestellt werden muss, dass jedes Fahrzeug sein richtiges Steuergerät erhält.

Vor diesem Hintergrund besteht die Aufgabe der Erfindung in der Angabe eines Steuergerätes, bei dem die genannten Nachteile nicht auftreten. Mit Blick auf Verfahrensaspekte besteht die Aufgabe der Erfindung in der Angabe eines Verfahrens der eingangs genannten Art, mit dem sich die genannten Nachteile vermeiden lassen. Diese Aufgabe wird mit Blick auf ihre Vorrichtungsaspekte mit den Merkmalen des unabhängigen Anspruchs 1 und mit Blick auf ihre Verfahrensaspekte durch die Merkmale des unabhängigen Verfahrensanspruchs gelöst.

Diese Merkmale erlauben eine Anpassung des Steuergerätes an anzuschließende Sensoren, die keine Änderungen der Steuergeräte-Hardware erfordert und die stattdessen durch reine Steuerbefehle erfolgt, mit denen alternativ der Pull-up-Schalter oder der Pull-down-Schalter eines Eingangs geschlossen wird.

Dadurch kann die Anpassung zum Beispiel bei der Kraftfahrzeugfertigung durch eine Bandende-Programmierung des Steuergeräts erfolgen. Damit können gleiche Steuergeräte für verschiedene Ausstattungsvarianten der Fahrzeuge mit anzuschließenden Sensoren verwendet werden. Die Logistik der Fahrzeugfertigung wird vereinfacht, da an einer Montagestation in der Fahrzeugfertigung nur ein Steuergerätetyp verarbeitet und angeliefert werden muss. Die Vereinfachungen wirken sich auch auf die Ersatzteilhaltung aus, weil die Erfindung die Zahl der als Ersatzteil bereitzuhaltenden Steuergerätetypen reduziert. All dies wirkt sich kostensenkend aus.

Weitere Vorteile ergeben sich aus den Unteransprüchen, der Beschreibung und den beigefügten Figuren.

Es versteht sich, dass die vorstehend genannten und die nachstehend noch zu erläuternden Merkmale nicht nur in der jeweils angegebenen Kombination, sondern auch in anderen Kombinationen oder in Alleinstellung verwendbar sind, ohne den Rahmen der vorliegenden Erfindung zu verlassen.

### Zeichnungen

Ausführungsbeispiele der Erfindung sind in den Zeichnungen dargestellt und werden in der nachfolgenden Beschreibung näher erläutert. Es zeigen, jeweils in schematischer Form:
- Figur 1: einen Analogsensor, der an ein bekanntes Steuergerät angeschlossen ist;
- Figur 2: einen PWM-Sensor, der an ein bekanntes Steuergerät angeschlossen ist;
- Figur 3: einen Analogsensor, der an ein ebenfalls bekanntes Steuergerät angeschlossen ist;
- Figur 4: einen PWM-Sensor, der an ein ebenfalls bekanntes Steuergerät angeschlossen ist;
- Figur 5: ein erstes Ausführungsbeispiel eines erfindungsgemäßen Steuergerätes;
- Figur 6: ein zweites Ausführungsbeispiel eines erfindungsgemäßen Steuergerätes; und
- Figur 7: ein Ausführungsbeispiel eines erfindungsgemäßen Verfahrens.

Dabei bezeichnen gleiche Bezugszeichen in den verschiedenen Figuren jeweils gleiche oder zumindest ihrer Funktion nach gleiche Elemente.

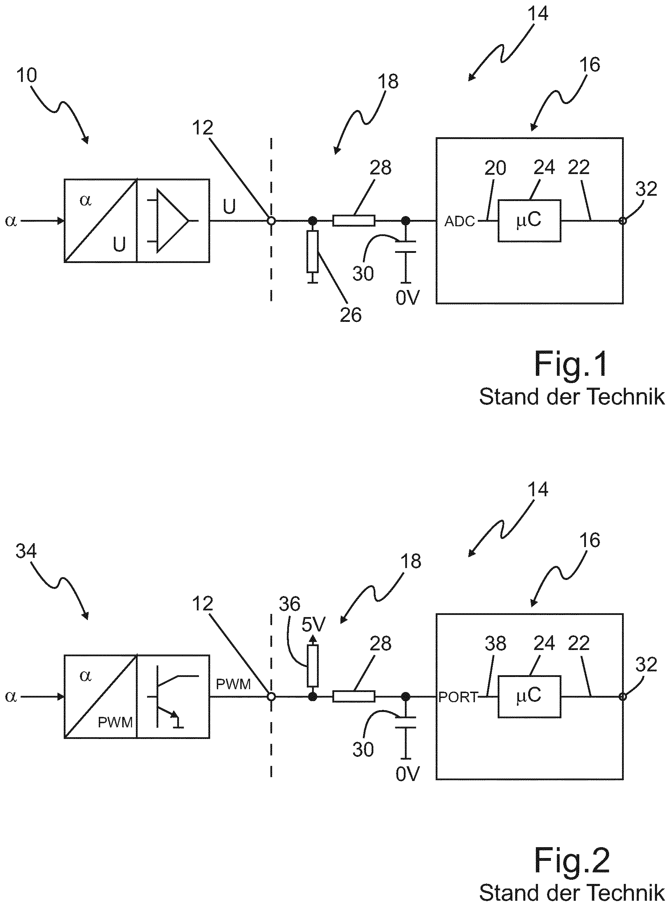

Im Einzelnen zeigt die Figur 1 einen Analogsensor 10, der an einen Eingangsanschluss 12 eines Steuergerätes 14 angeschlossen ist. Der Analogsensor 10 ist dazu eingerichtet, eine physikalische Größe α zu erfassen und in einem analogen Signal U abzubilden, das als Ausgangssignal des Analogsensors 10 bereitgestellt wird. Die physikalische Größe α ist einer bevorzugten Ausgestaltung ein Neigungswinkel einer Fahrzeugkarosserie oder eine andere physikalische Größe, in der sich die Neigung der Fahrzeugkarosserie abbildet, zum Beispiel eine Auslenkung eines Fahrwerkteils des Kraftfahrzeugs.

Das Steuergerät 14 weist einen zentralen Bereich 16 und einen peripheren Bereich 18 auf. Der zentrale Bereich 16 weist einen Eingangskanal 20, einen Ausgangskanal 22 und einen Signale aus dem Eingangskanal 20 zu Ausgangssignalen für den Ausgangskanal 22 verarbeitenden Mikrocomputer 24 mit Rechen- und Speicherfähigkeiten auf. Der periphere Bereich 18 weist eine Eingangsschaltung auf, mit der das vom Analogsensor 10 bereitgestellte Analogsignal U so aufbereitet wird, dass es in den Eingangskanal 20 des zentralen Bereichs 16 des Steuergerätes 14 eingespeist werden kann.

Analogsensoren sind in der Regel Stromquellen. Um ein Referenzpotenzial für einen solchen Stromquellen-Sensor bereitzustellen, weist die Eingangsschaltung des peripheren Bereichs 18 des Steuergeräts 14 aus der Figur 1 einen Pull-down-Widerstand 26 auf. Durch den Pull-down-Widerstand 26 ergibt sich im stromlosen Zustand, also wenn kein Analogsensor 10 an den Eingangsanschluss 12 angeschlossen ist, ein tiefes Potenzial in Form des Massepotenzials am Eingangsanschluss 12 und damit auch am Eingangskanal 20 des zentralen Bereichs 16.

Der Eingangskanal 20 ist bei dieser Ausgestaltung als Analog-Digital-Wandler (ADC) ausgeführt. Die Eingangsschaltung des peripheren Bereichs 18 weist über den Pull-down-Widerstand 26 noch einen Tiefpass aus einem Widerstand 28 und einer Kapazität 30 auf. Dieser Tiefpass dient der Filterung der Analogsignale U und zum Schutz gegen Überspannungen. Der Mikrocomputer 24 verarbeitet die über den Analog-Digital-Wandler (ADC) in Digitalsignale umgewandelten Signale des Analogsensors 10 und gegebenenfalls weitere Signale von in der Figur 1 nicht dargestellten Sensoren unter Rückgriff auf gespeicherte Daten und Programme zu einer Stellgröße, die über den Ausgangskanal 22 an einem Ausgang 32 des zentralen Bereichs 16 und/oder des Steuergeräts 14 bereitgestellt wird. Im Falle einer Leuchtweitenregelung dient eine solche Stellgröße zur Verstellung der Leuchtweite eines Lichtmoduls eines Frontscheinwerfers des Kraftfahrzeugs, mit der ein unerwünschter Einfluss einer Fahrzeugneigung auf die Leuchtweite kompensiert wird.

Figur 2 zeigt einen PWM-Sensor, der an einen Eingangsanschluss 12 eines Steuergeräts 14 angeschlossen ist. PWM-Sensoren 34 erfassen eine physikalische Größe α und bilden diese in dem Tastverhältnis eines pulsweitenmodulierten Signals PWM ab. PWM-Sensoren 34 sind in der Regel Stromsenken-Sensoren. Für einen solchen Stromsenken-Sensor 34 ist eine Eingangsschaltung vorteilhaft, bei der der Eingangsanschluss 12 über einen Pull-up-Widerstand 36 an ein vergleichsweise höheres Potenzial angeschlossen ist. Das vergleichsweise höhere Potenzial kann zum Beispiel ein Fünf-Volt-Potenzial sein, wenn das vergleichsweise tiefere Potenzial ein Massepotenzial mit null Volt ist.

Wie auch beim Gegenstand der Figur 1, dient ein Tiefpassfilter aus einem Widerstand 28 und einer Kapazität 30 auch beim Gegenstand der Figur 2 zur Filterung der Eingangssignale und zum Schutz des nachfolgenden Eingangskanals 38 vor Überspannungen.

Der Eingangskanal 38 ist beim Gegenstand der Figur 2 bevorzugt als digitale Capture/Compare-Funktion ausgebildet. Ein Vergleich der Figuren 1 und 2 zeigt, dass sich die Topologien der Eingangsschaltungen in den peripheren Bereichen 18 sowohl hinsichtlich der Bauelementeanordnung als auch hinsichtlich der notwendigen Ressourcen im zentralen Bereich 16 des Steuergeräts 14 unterscheiden. Während man zur Auswertung eines Analogsensors 10 einen ADC-Eingangskanal 20 benötigt, muss für die Auswertung eines PWM-Sensors 34 ein digitaler Port (idealerweise mit Capture/Compare-Funktion) bereitgestellt werden.

Sowohl die Figur 1 als auch die Figur 2 zeigen jeweils nur einen an das Steuergerät 14 angeschlossenen Sensor und damit jeweils auch nur einen Eingang. Normalerweise sind im auswertenden Steuergerät 14 weitere Sensoreingänge vorhanden, wobei die Zahl der Eingänge größer oder gleich der Zahl der an das Steuergerät 14 anzuschließenden Sensoren ist.

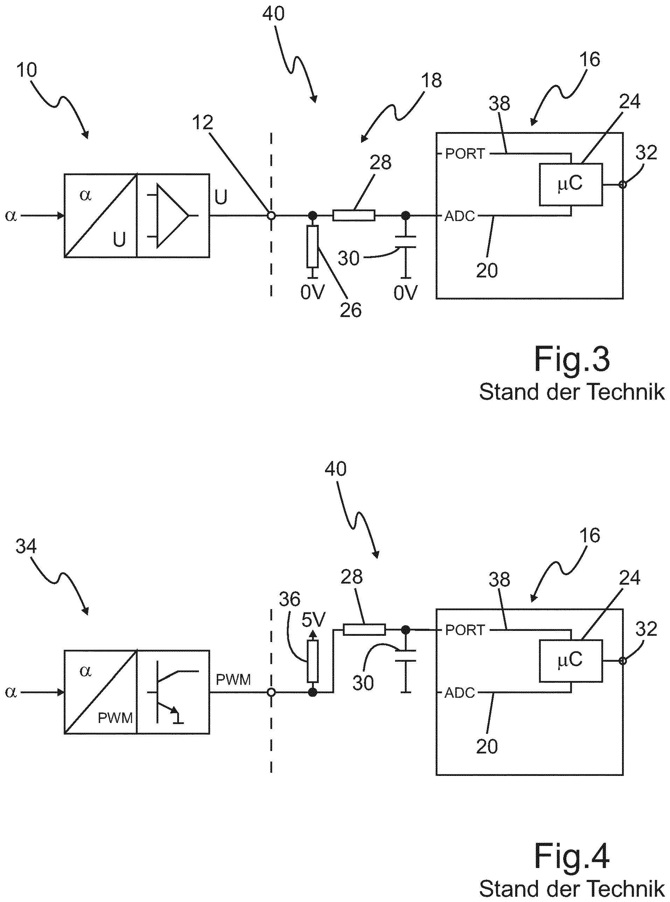

Figur 3 zeigt, ähnlich wie Figur 1, einen Analogsensor 10, der an einen Eingangsanschluss 12 eines ebenfalls bekannten Steuergerätes 40 angeschlossen ist. Das Steuergerät 40 unterscheidet sich vom Steuergerät 14 aus der Figur 1 dadurch, dass es für einen Eingangsanschluss 12 sowohl einen analogen Eingangskanal 20 als auch einen digitalen Eingangskanal 38 bereitstellt. Das Steuergerät 40 aus der Figur 3 bietet insofern bereits mehr Flexibilität als das Steuergerät 14 aus der Figur 1, weil es sowohl einen Anschluss eines Analogsensors 10, als auch einen Anschluss eines PWM-Sensors 34 an den gleichen Eingangsanschluss 12 erlaubt. Für den Anschluss eines Analogsensors 10 an den Eingangsanschluss 12 wird der Eingangsanschluss 12 innerhalb des Steuergerätes 40 mit einer Eingangsschaltung an den ADC-Eingangskanal 20 des zentralen Bereichs 16 des Steuergerätes 40 angeschlossen, wie sie bereits unter Bezug auf die Figur 1 erläutert worden ist. Diese Eingangsschaltung zeichnet sich insbesondere dadurch aus, dass der Eingangsanschluss 12 innerhalb des Steuergerätes 40 mit dem Pull-down-Widerstand 26 an ein tiefes Potenzial, zum Beispiel das auf null Volt liegende Massepotenzial, angebunden ist. Die Eingangsschaltung verbindet den Eingangsanschluss 12 innerhalb des Steuergerätes 40 mit dem ADC-Eingangskanal 20 und weist über den Pull-down-Widerstand 26 hinaus den bereits unter Bezug auf die Figur 1 erläuterten Tiefpass aus einem Widerstand 28 und einer Kapazität 30 auf.

Figur 4 zeigt das Steuergerät 40 aus der Figur 3 mit der alternativen Eingangsschaltung, die bereits unter Bezug auf die Figur 2 erläutert worden ist und die sich insbesondere dadurch auszeichnet, dass der Eingangsanschluss 12 über einen Pull-up-Widerstand 36 an ein vergleichsweise höheres Potenzial, zum Beispiel ein Potenzial von fünf Volt, angebunden ist. Diese Eingangsschaltung dient, wie bereits unter Bezug auf die Figur 2 erläutert worden ist, zum Anschluss eines PWM-Sensors 34 an den Eingangsanschluss 12. Dabei wird der Eingangsanschluss 12 über die Eingangsschaltung, die in der dargestellten Ausgestaltung neben dem Pull-up-Widerstand 36 noch einen Tiefpass aus einem Widerstand 28 und einer Kapazität 30 aufweist, mit dem digitalen Eingangskanal (Port) 38 des zentralen Bereichs 16 des Steuergerätes 40 verbunden.

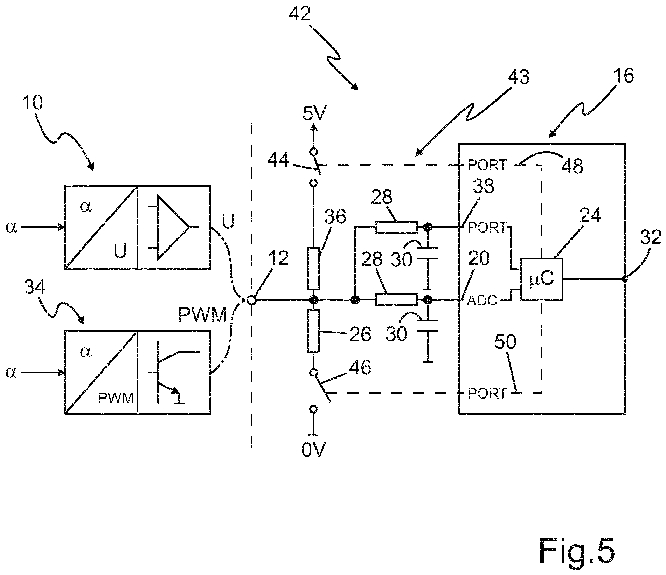

Figur 5 zeigt ein erstes Ausführungsbeispiel eines erfindungsgemäßen Steuergerätes 42. Das Steuergerät 42 zeichnet sich dadurch aus, dass seine Eingangsschaltung 43, die den Eingangsanschluss 12 mit dem zentralen Bereich 16 verbindet, einen ersten, vom Steuergerät 42 betätigbaren Pull-up-Schalter 44 aufweist, der eine Anbindung des Eingangsanschlusses 12 an ein hohes Potenzial steuert, und es zeichnet sich ferner dadurch aus, dass eine Eingangsschaltung 43 einen zweiten, vom Steuergerät 42 steuerbaren Schalter 46 aufweist, der eine Anbindung des Eingangsanschlusses an ein tiefes Potenzial steuert und daher als Pull-down-Schalter 46 bezeichnet werden kann.

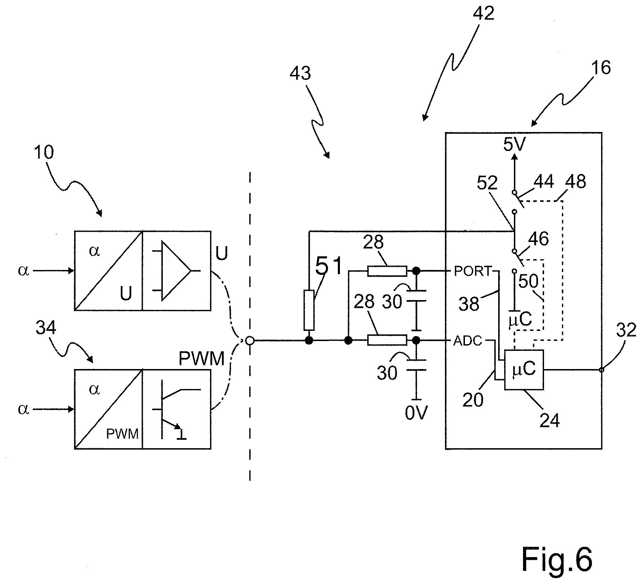

Das hohe Potenzial kann bei diesem Ausführungsbeispiel und auch bei dem noch folgenden Ausführungsbeispiel, das in der Figur 6 dargestellt ist, fünf Volt betragen, ohne auf einen solchen Wert festgelegt zu sein. Das tiefe Potenzial kann null Volt betragen, ohne auf einen solchen Wert festgelegt zu sein.

Der Pull-up-Schalter 44 wird in einer Ausgestaltung über einen vom Mikrocomputer 24 gesteuerten eigenen digitalen Port 48 gesteuert. Der Pull-down-Schalter 46 wird in einer Ausgestaltung über einen eigenen digitalen Port 50 vom Mikrocomputer 24 gesteuert. Die Steuerung erfolgt dabei so, dass dann, wenn einer der beiden Schalter 44, 46 geschlossen wird, der andere Schalter geöffnet wird. Insofern erfolgt die Ansteuerung der beiden Schalter 44 und 46 komplementär zueinander. Die Komplementarität der Ansteuerung macht es auch möglich, beide Schalter 44 und 46 über ein und denselben Port zu steuern, wenn die Schalter 44 und 46 als zueinander komplementäre Schalter einer CMOS-Logik ausgeführt sind. Der eine der beiden Schalter 44 und 46 wäre dann als NMOS-Transistor und der andere der beiden Schalter 44 und 46 wäre dann als PMOS-Transistor auszuführen.

In einer alternativen Ausgestaltung sind die beiden Schalter 44 und 46 als komplementäre Bipolar-Transistoren ausgeführt, also einer als pnp-Transistor, und einer als npn-Transistor. Bevorzugt ist auch, dass der Pull-up-Schalter 44 mit dem Pull-up-Widerstand 36 in Reihe liegt und dass der Pull-down-Schalter 46 mit dem Pull-down-Widerstand 26 in Reihe liegt. Im Übrigen zeichnet sich die Eingangsschaltung 43 dadurch aus, dass sie sowohl den analogen Eingangskanal 20 als auch den digitalen Eingangskanal 38 des zentralen Bereichs 16 des Steuergeräts 42 mit dem Eingangsanschluss 12 verbindet.

In den Ausführungsbeispielen, die in den Figuren 5 und 6 dargestellt sind, erfolgt dies jeweils über einen Tiefpass aus einem Widerstand 28 und einer Kapazität 30. Der Tiefpass dient auch hier zur Filterung der Eingangssignale und zum Schutz der Eingangskanäle 20, 38 vor Überspannungen. Der Tiefpass stellt dabei jeweils lediglich eine Ausgestaltung eines Filternetzwerks dar, mit dem ein Eingangskanal 20 oder 38 mit dem Eingangsanschluss 12 verbunden ist. Sowohl der analoge Eingangskanal 20 als auch der digitale Eingangskanal 38 besitzt einen eigenen Tiefpass, beziehungsweise ein eigenes Filternetzwerk.

Dass die Widerstände 28 und die Kapazitäten 30 der beiden Eingangskanäle 20 und 38 des zentralen Bereichs 16 des Steuergeräts 42 die gleichen Bezugszeichen aufweisen, deutet an, dass sie in einer Ausgestaltung jeweils gleiche Impedanzen besitzen. In einer alternativen Ausgestaltung können die Bauteile des Filternetzwerkes des digitalen Eingangskanals 38 auch andere Impedanz-Werte besitzen als die Bauteile des Filternetzwerks des analogen Eingangskanals 20.

Das am Eingangsanschluss 12 anliegende Eingangssignal wird damit, unabhängig, ob es von einem Analogsensor 10 oder einem PWM-Sensor 34 erzeugt wird, sowohl an den einen ADC-Wandler aufweisenden Analogeingangskanal 20 als auch an den digitalen Eingangskanal 38 angelegt. Für den Fall, dass ein Analogsensor 10 an den Eingangsanschluss 12 angeschlossen ist, wird der Pull-up-Schalter 44 geöffnet, und der Pull-down-Schalter 46 geschlossen, um die Eingangsimpedanz der Eingangsschaltung 43 an die Signale des Analogsensors 10 anzupassen. Ist dagegen ein PWM-Sensor 34 an den Eingangsanschluss 12 angeschlossen, wird der Pull-up-Schalter 44 geschlossen, und gleichzeitig wird der Pull-down-Schalter 46 geöffnet, um die Eingangsimpedanz der Eingangsschaltung 43 an die Signale des PWM-Sensors 34 anzupassen.

Das Signal des Sensors, der an den Eingangsanschluss 12 angeschlossen ist, liegt dann sowohl an dem analogen Eingangskanal 20 als auch an dem digitalen Eingangskanal 38 an. Von diesen, an beiden Eingangskanälen 20, 38 anliegenden Signalen verarbeitet der Mikrocomputer 24 anschließend entweder nur die Signale des Eingangskanals 20 oder des Eingangskanals 38. Welche Signale er verarbeitet, hängt davon ab, ob er den Pull-up-Schalter 44 oder den Pull-down-Schalter 46 geschlossen hat. Mit dem Schließen des Pull-down-Schalters 46 wählt der Mikrocomputer 24 auch gespeicherte Software-Strukturen aus, die an eine Verarbeitung der Signale von Analogsensoren 10 adaptiert sind. Umgekehrt wählt der Mikrocomputer 24 mit dem Schließen des Pull-up-Schalters 44 auch gespeicherte Software-Strukturen aus, die an eine Verarbeitung der Signale von PWM-Sensoren 34 adaptiert sind.

Im Ausführungsbeispiel, das in der Figur 5 dargestellt ist, ist sowohl der Pull-up-Schalter 44 als auch der Pull-down-Schalter 46 ein Bestandteil der Eingangsschaltung 43.

Die Figur 6 zeigt ein weiteres Ausführungsbeispiel, bei dem in einem digitalen Port ohnehin vorhandene High-Side-Schalter und Low-Side-Schalter als Pull-up-Schalter 44 und Pull-down-Schalter 46 verwendet werden. Diese Ausgestaltung zeichnet sich dadurch aus, dass die Eingangsschaltung 43 dann keine separaten Pull-up-Schalter und Pull-down-Schalter mehr aufweisen muss, was die Zahl der benötigten Bauteile und damit auch den Flächenbedarf der Eingangsschaltung und die für die Realisierung der Eingangsschaltung aufzuwendenden Kosten reduziert. Ein weiterer Vorteil besteht darin, dass sich das Ausführungsbeispiel aus der Figur 6 dafür anbietet, die beiden Widerstände 26 und 36 des Ausführungsbeispiels der Figur 5 durch einen einzigen Widerstand 51 zu ersetzen, der zwischen dem Eingangsanschluss 12 und einem Mittelabgriff 52 liegt, der zwischen den beiden in Reihe liegenden Schaltern 44 und 46 angeschlossen ist.

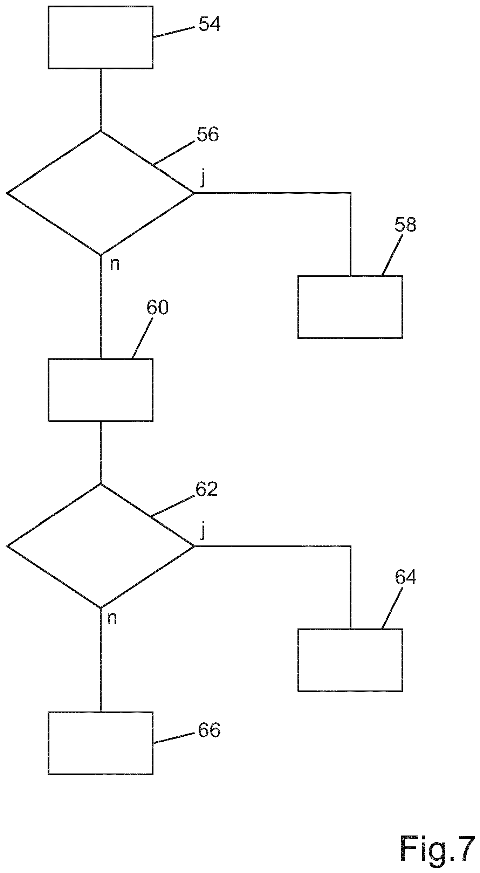

Die Ausführungsbeispiele, die in den Figuren 6 und 7 dargestellt sind, zeigen mit den zwischen dem Eingangsanschluss 12 und den im Mikrocomputer 24 liegenden Schaltungstopologien jeweils Ausgestaltungen eines durch Schaltsignale konfigurierbaren Universalsensoreingangs eines Steuergerätes 42, der mit einer einzigen Eingangsschaltung 43 prinzipiell sowohl ein analoges Signal als auch ein PWM-Signal auswerten kann, und der erst im Moment des Einbaus des Steuergerätes 42 in ein Kraftfahrzeug oder zu einem noch späteren Zeitpunkt passend zum jeweils angeschlossenen Sensortyp konfiguriert wird. Dabei wird unter einer Konfiguration hier eine Anpassung der Eingangsimpedanz des Universalsensoreingangs und eine Auswahl und Aktivierung der für die Auswertung der Sensorsignale erforderlichen und an den jeweiligen Sensortyp angepassten Softwarestrukturen verstanden.

Die Konfiguration kann zum Beispiel durch eine Bandende-Programmierung oder aber auch durch eine vom Steuergerät 42 selbst durchgeführte Autodetektion des angeschlossenen Sensortyps im Rahmen der für den späteren Betrieb des angeschlossenen Sensors erforderlichen NullpunktsProgrammierung erfolgen. Unter der NullpunktsProgrammierung wird dabei verstanden, dass das Steuergerät 42 den Wert des Sensorsignals in einem definierten Zustand des Kraftfahrzeugs erfasst und als Referenzwert, beispielsweise als Nullpunkt, abspeichert.

In einer bevorzugten Ausgestaltung von Verfahrensaspekten der Erfindung wird dieser Nullpunktsprogrammierung eine Schrittfolge vorgeschaltet, mit der die anliegenden Sensorsignale analysiert werden und mit denen auf den im jeweiligen Fahrzeugtyp eingebauten Sensortyp, beziehungsweise auf die Zahl und die Typen der eingebauten Sensoren geschlossen wird, um diese Informationen von da an für die Auswertung der angeschlossenen Sensoren zu verwenden.

Figur 7 zeigt ein Flussdiagramm als Ausführungsbeispiel eines solchen Verfahrens. Im Schritt 54 wird die Schrittfolge gestartet, wobei der Start insbesondere am Bandende, das heißt nach dem Einbau des Steuergerätes und dem Anschluss der Sensoren, an Eingangsanschlüsse 12 des Steuergeräts 42 erfolgt. In einer Ausgestaltung wird im Schritt 54 zusammen mit dem Start der Pull-down-Schalter 46 geschlossen und der Pull-up-Schalter 44 geöffnet. Damit wird die Eingangsimpedanz der Eingangsschaltung 43 eines Steuergerätes 42, wie es im Zusammenhang mit den Figuren 5 und 6 erläutert worden ist, an einen Analogsensor 10 angepasst.

Im Schritt 56 überprüft der Mikrocomputer 24 dann, ob an seinem Eingangsanschluss 12 eine konstante Gleichspannung U anliegt, deren Wert in einem erlaubten Bereich Uu < U < Uo liegt. Die untere Grenze Uu des erlaubten Bereichs liegt zum Beispiel bei zwei Volt und die Obergrenze Uo des erlaubten Bereichs liegt zum Beispiel bei drei Volt. Wird im Schritt 56 eine plausible Gleichspannung, das heißt eine in dem genannten erlaubten Bereich liegende Gleichspannung U erkannt, wird die Abfrage im Schritt 56 bejaht und das Programm verzweigt in dem Schritt 58.

Im Schritt 58 wird gespeichert, dass ein Analogsensor 10 an den Eingangsanschluss 12 angeschlossen ist. Darüber hinaus werden im Schritt 58 dafür angepasste Software-Strukturen für die spätere Auswertung der Sensorsignale des Analogsensors 10 ausgewählt. Um eine solche Auswahl zu ermöglichen, sind im Steuergerät 42 bevorzugt sämtliche Software-Strukturen hinterlegt, die für die Auswertung von potenziell an den Eingangsanschluss 12 anzuschließenden Sensoren angepasst sind.

Wird die Abfrage im Schritt 56 dagegen verneint, kann dies bedeuten, dass entweder gar kein Sensor an den Eingangsanschluss 12 angeschlossen ist oder dass ein PWM-Sensor 34 an den Eingangsanschluss 12 angeschlossen ist. Um diese beiden Fälle zu unterscheiden, wird im anschließenden Schritt 60 der Pull-down-Strompfad durch Öffnen des Pull-down-Schalters 46 deaktiviert und der Pull-up-Strompfad durch Schließen des Pull-up-Schalters 44 aktiviert. Dadurch wird die Eingangsimpedanz der Eingangsschaltung 43 an einen PWM-Sensor angepasst.

Die Schrittfolge 60, 62, 64 kann auch vor der Schrittfolge 54, 56, 58 durchgeführt werden. Es spielt keine Rolle, ob zunächst geprüft wird, ob ein PWM-Sensor angeschlossen ist oder ob ein Analog-Sensor angeschlossen ist.

Anschließend wird im Schritt 62 überprüft, ob an dem Eingangsanschluss 12 ein Signal mit einer für einen PWM-Sensor 34 plausiblen Frequenz anliegt. Dies erfolgt in einer Ausgestaltung dadurch, dass eine Frequenz des an dem Eingangsanschluss 12 anliegenden Signals mit einer unteren Frequenzschwelle fu und einer oberen Frequenzschwelle fo verglichen wird. Wenn die festgestellte Frequenz innerhalb des von den Frequenzschwellen fu und fo begrenzten Intervalls liegt, wird die Abfrage im Schritt 62 bejaht und das Programm verzweigt in den Schritt 64.

Im Schritt 64 wird abgespeichert, dass ein PWM-Sensor 34 an den Eingangsanschluss 12 angeschlossen ist, und es werden für eine Auswertung der Signale eines solchen PWM-Sensors 34 angepasste Software-Strukturen für den späteren Betrieb der Kombination aus diesem Sensortyp und dem Steuergerät 42 ausgewählt.

Wenn die Abfrage im Schritt 62 dagegen verneint wird, verzweigt das Programm in einen Schritt 66, in dem eine Fehlermeldung abgespeichert und/oder einem Bediener signalisiert wird. Die abzuspeichernde oder anzuzeigende Fehlermeldung besagt dabei, dass an den Eingangsanschluss 12 kein funktionsfähiger Sensor 10 oder 34 angeschlossen ist.

Für den üblichen Fall, dass das Steuergerät 42 eine Vielzahl von konfigurierbaren Eingängen aufweist, wird das Autodetektionsverfahren, von dem eine Ausgestaltung unter Bezug auf die Figur 7 erläutert worden ist, für jeden der konfigurierbaren Sensoreingänge durchlaufen. Wird dabei an einem Eingang weder ein Analogsensor 10 noch ein PWM-Sensor 34 erkannt, wird der entsprechende Eingang deaktiviert und bei der Signalauswertung im späteren Betrieb des Steuergerätes nicht berücksichtigt.

Diese Konstellation kann zum Beispiel dann auftreten, wenn das individuelle Fahrzeug nur zwei Sensoren für eine bestimmte Funktion wie die Leuchtweitenregelung benötigt, das Steuergerät für diese Funktion aber drei Eingänge anbietet, um auch weitere Fahrzeugvarianten abzudecken. In einer bevorzugten Ausgestaltung wird die gefundene Konfiguration, hier die Konfiguration mit zwei Sensoren, einem Bediener signalisiert. So können am Bandende Fehler der Sensoren und/oder der Zahl angeschlossener Sensoren erkannt werden.

Das erfindungsgemäße Steuergerät zeichnet sich insbesondere auch dadurch aus, dass es dazu eingerichtet ist, dass hier vorgestellte Verfahren und/oder eine seiner Ausgestaltungen auszuführen, wobei unter einer Ausführung die Steuerung des Verfahrensablaufs verstanden wird.

## Patentansprüche

1. Steuergerät (42), das dazu eingerichtet ist, in einem Kraftfahrzeug verwendet zu werden und dabei Sensorsignale zu verarbeiten und daraus Stellgrößen zu erzeugen, mit denen Stellglieder des Kraftfahrzeugs ansteuerbar sind, um das Verhalten des Kraftfahrzeuges und/oder von Teilen des Kraftfahrzeugs im Betrieb zu beeinflussen, und das wenigstens einen Eingang mit einem Eingangsanschluss (12), wenigstens zwei Eingangskanälen (20, 38) und einer Eingangsschaltung (43) aufweist, und das dazu eingerichtet ist, Signale eines Sensors (10, 34) über den Eingangsanschluss (12) aufzunehmen und über die Eingangsschaltung (43) in einen Eingangskanal (20, 38) des Eingangs einzuspeisen, wobei der Eingangsanschluss (12) über einen Widerstand an ein definiertes Potenzial angebunden ist, wobei die Eingangsschaltung (43) einen ersten vom Steuergerät (42) betätigbaren Pull-Up-Schalter (44) aufweist, der eine Anbindung des Eingangsanschlusses (12) an ein hohes Potenzial steuert, und einen zweiten vom Steuergerät (42) betätigbaren Pull-Down-Schalter (46) aufweist, der eine Anbindung des Eingangsanschlusses (12) an ein tiefes Potenzial steuert, **dadurch gekennzeichnet, dass** das Steuergerät dazu eingerichtet ist, den Pull-down-Schalter (46) zu schließen und den Pull-up-Schalter (44) zu öffnen, und zu überprüfen, ob an einem Eingangskanal (20) eine konstante Gleichspannung U anliegt, deren Wert in einem erlaubten Bereich Uu < U < Uo liegt, und dann, wenn dies der Fall ist, zu speichern, dass ein Analogsensor (10) an den Eingangsanschluss (12) angeschlossen ist, und dafür angepasste Software-Strukturen für die spätere Auswertung der Sensorsignale des Analogsensors (10) auszuwählen, und/oder den Pull-down-Strompfad durch Öffnen des Pull-down-Schalters (46) zu deaktivieren und den Pull-up-Strompfad durch Schließen des Pull-up-Schalters (44) zu aktivieren und zu überprüfen, ob an dem Eingangsanschluss (12) ein Signal mit einer zwischen einer unteren Frequenzschwelle fu und einer oberen Frequenzschwelle fo liegenden mit einer für einen PWM-Sensor plausiblen Frequenz anliegt und dann, wenn dies der Fall ist, abzuspeichern, dass ein PWM-Sensor (34) an den Eingangsanschluss (12) angeschlossen ist, und für eine Auswertung der Signale eines solchen PWM-Sensors (34) angepasste Software-Strukturen für den späteren Betrieb der Kombination aus diesem Sensortyp und dem Steuergerät (42) auszuwählen.

2. Steuergerät (42) nach Anspruch 1, **dadurch gekennzeichnet, dass** das Steuergerät (42) dazu eingerichtet ist, den Pull-up-Schalter (44) über einen vom Mikrocomputer (24) gesteuerten, eigenen digitalen Port (48) und den Pull-down-Schalter (46) über einen eigenen, digitalen Port (50) vom Mikrocomputer (24) steuern zu lassen.

3. Steuergerät (42) nach Anspruch 2, **dadurch gekennzeichnet, dass** das Steuergerät (42) dazu eingerichtet ist, dann, wenn einer der beiden Schalter (44, 46) geschlossen wird, den jeweils anderen Schalter zu öffnen.

4. Steuergerät (42) nach Anspruch 1, **dadurch gekennzeichnet, dass** die beiden Schalter (44) und (46) komplementäre Feldeffekt-Transistoren oder komplementäre Bipolar-Transistoren sind und dass das Steuergerät (42) dazu eingerichtet ist, beide Schalter über ein und denselben Port zu steuern.

5. Steuergerät (42) nach einem der vorhergehenden Ansprüche, **dadurch gekennzeichnet, dass** der Pull-up-Schalter (44) mit dem Pull-up-Widerstand (36) in Reihe liegt und dass der Pull-down-Schalter (46) mit dem Pull-down-Widerstand (26) in Reihe liegt.

6. Steuergerät (42) nach einem der vorhergehenden Ansprüche, **dadurch gekennzeichnet, dass** die Eingangsschaltung (43) sowohl einen analogen Eingangskanal (20) als auch einen digitalen Eingangskanal (38) eines zentralen Bereichs (16) des Steuergeräts (42) mit dem Eingangsanschluss (12) verbindet.

7. Steuergerät (42) nach einem der vorhergehenden Ansprüche, **dadurch gekennzeichnet, dass** der Pull-up-Schalter (44) und der Pull-down-Schalter (46) durch in einem digitalen Port ohnehin vorhandene High-Side-Schalter und Low-Side-Schalter realisiert werden.

8. Verfahren zum Anpassen eines Steuergeräts (42) an einen an das Steuergerät (42) anzuschließenden Sensor (10, 34), wobei das Steuergerät (42) dazu eingerichtet ist, in einem Kraftfahrzeug verwendet zu werden und dabei Sensorsignale zu verarbeiten und daraus Stellgrößen zu erzeugen, mit denen Stellglieder des Kraftfahrzeugs ansteuerbar sind, um das Verhalten des Kraftfahrzeuges und/oder von Teilen des Kraftfahrzeugs im Betrieb zu beeinflussen und wenigstens einen Eingang mit einem Eingangsanschluss (12), wenigstens zwei Eingangskanälen (20, 38) und einer Eingangsschaltung (43) aufweist, und dazu eingerichtet ist, Signale des Sensors (10, 34) über den Eingangsanschluss (12) aufzunehmen und über die Eingangsschaltung (43) in einen Eingangskanal (20, 38) des Eingangs einzuspeisen, wobei das Anpassen den Schritt eines über einen Widerstand erfolgenden Anbindens des Eingangsanschlusses (12) an ein definiertes Potenzial umfasst, wobei das über einen Widerstand erfolgende Anbinden des Eingangsanschlusses (12) über einen ersten vom Steuergerät (42) betätigbaren Pull-Up-Schalter (44) erfolgt, der eine Anbindung des Eingangsanschlusses (12) an ein hohes Potenzial steuert, oder dass das Anbinden über einen zweiten vom Steuergerät (42) betätigbaren Pull-Down-Schalter (46) erfolgt, der eine Anbindung des Eingangsanschlusses (12) an ein tiefes Potenzial steuert, **dadurch gekennzeichnet, dass** der Pull-down-Schalter (46) geschlossen und der Pull-up-Schalter (44) geöffnet wird, und dass überprüft wird, ob an einem Eingangskanal (20) eine konstante Gleichspannung U anliegt, deren Wert in einem erlaubten Bereich Uu < U < Uo liegt, und dass dann, wenn dies der Fall ist, gespeichert wird, dass ein Analogsensor (10) an den Eingangsanschluss (12) angeschlossen ist, und dass dafür angepasste Software-Strukturen für die spätere Auswertung der Sensorsignale des Analogsensors (10) ausgewählt werden und/oder dass der Pull-down-Strompfad durch Öffnen des Pull-down-Schalters (46) deaktiviert und der Pull-up-Strompfad durch Schließen des Pull-up-Schalters (44) aktiviert wird und dass überprüft wird, ob an dem Eingangsanschluss (12) ein Signal mit einer zwischen einer unteren Frequenzschwelle fu und einer oberen Frequenzschwelle fo liegenden mit einer für einen PWM-Sensor plausiblen Frequenz anliegt und dass dann, wenn dies der Fall ist, abgespeichert wird, dass ein PWM-Sensor (34) an den Eingangsanschluss (12) angeschlossen ist, und dass für eine Auswertung der Signale eines solchen PWM-Sensors (34) angepasste Software-Strukturen für den späteren Betrieb der Kombination aus diesem Sensortyp und dem Steuergerät (42) ausgewählt werden.

## Claims

1. Control device (42) which is designed to be used in a motor vehicle and to process sensor signals and to produce manipulated variables therefrom by means of which actuators of the motor vehicle can be controlled in order to influence the behavior of the motor vehicle and/or of parts of the motor vehicle during operation, and which comprises at least one input that has an input port (12), at least two input channels (20, 38) and an input circuit (43), and which is designed to receive signals from a sensor (10, 34) via the input port (12) and to feed said signals via the input circuit (43) into an input channel (20, 38) of the input, the input port (12) being connected to a defined potential via a resistor, the input circuit (43) comprising a first pull-up switch (44) that can be actuated by the control device (42) and controls a connection of the input port (12) to a high potential, and comprising a second pull-down switch (46) that can be actuated by the control device (42) and controls a connection of the input port (12) to a low potential, **characterized in that** the control device is designed to close the pull-down switch (46) and to open the pull-up switch (44), and to check whether a constant DC voltage U is applied to an input channel (20), the value of which voltage being within a permissible range Uu < U < Uo, and, if this is the case, to store the information that an analog sensor (10) is connected to the input port (12), and to select software structures adapted thereto for the subsequent evaluation of the sensor signals from the analog sensor (10), and/or to deactivate the pull-down current path by opening the pull-down switch (46) and to activate the pull-up current path by closing the pull-up switch (44) and to check whether a signal that has a frequency between a lower frequency threshold fu and an upper frequency threshold fo and is plausible for a PWM sensor is applied to the input port (12) and, if this is the case, to store the information that a PWM sensor (34) is connected to the input port (12), and to select software structures adapted to an evaluation of the signals from a PWM sensor (34) of this kind for the subsequent operation of the combination of this type of sensor and the control device (42).

2. Control device (42) according to claim 1, **characterized in that** the control device (42) is designed to allow the pull-up switch (44) to be controlled via a separate digital port (48) which is controlled by the microcomputer (24) and the pull-down switch (46) to be controlled by the microcomputer (24) via a separate digital port (50).

3. Control device (42) according to claim 2, **characterized in that** the control device (42) is designed, if one of the two switches (44, 46) is closed, to open the other switch.

4. Control device (42) according to claim 1, **characterized in that** the two switches (44) and (46) are complementary field-effect transistors or complementary bipolar transistors and **in that** the control device (42) is designed to control both switches via one and the same port.

5. Control device (42) according to any of the preceding claims, **characterized in that** the pull-up switch (44) is in series with the pull-up resistor (36) and **in that** the pull-down switch (46) is in series with the pull-down resistor (26).

6. Control device (42) according to any of the preceding claims, **characterized in that** the input circuit (43) connects both an analog input channel (20) and a digital input channel (38) of a central region (16) of the control device (42) to the input port (12).

7. Control device (42) according to any of the preceding claims, **characterized in that** the pull-up switch (44) and the pull-down switch (46) are realized by means of a high-side switch and a low-side switch already present in a digital port.

8. Method for adapting a control device (42) to a sensor (10, 34) to be connected to the control device (42), the control device (42) being designed to be used in a motor vehicle and to process sensor signals and to produce manipulated variables therefrom by means of which actuators of the motor vehicle can be controlled in order to influence the behavior of the motor vehicle and/or of parts of the motor vehicle during operation, and comprising at least one input that has an input port (12), at least two input channels (20, 38) and an input circuit (43), and being designed to receive signals from the sensor (10, 34) via the input port (12) and to feed said signals via the input circuit (43) into an input channel (20, 38) of the input, the adaptation comprising the step of connecting the input port (12) to a defined potential via a resistor, the connection of the input port (12) via a resistor occurring by means of a first pull-up switch (44) that can be actuated by the control device (42) and controls a connection of the input port (12) to a high potential, or the connection occurring by means of a second pull-down switch (46) that can be actuated by the control device (42) and controls a connection of the input port (12) to a low potential, **characterized in that** the pull-down switch (46) is closed and the pull-up switch (44) is opened, and **in that** it is checked whether a constant DC voltage U is applied to an input channel (20), the value of which voltage is within a permissible range Uu < U < Uo, and **in that**, if this is the case, the information that an analog sensor (10) is connected to the input port (12) is stored, and **in that** software structures adapted thereto are selected for the subsequent evaluation of the sensor signals from the analog sensor (10) and/or **in that** the pull-down current path is deactivated by opening the pull-down switch (46) and the pull-up current path is activated by closing the pull-up switch (44) and **in that** it is checked whether a signal that has a frequency between a lower frequency threshold fu and an upper frequency threshold fo and is plausible for a PWM sensor is applied to the input port (12) and **in that**, if this is the case, the information that a PWM sensor (34) is connected to the input port (12) is stored, and **in that** software structures adapted to an evaluation of the signals from a PWM sensor (34) of this kind are selected for the subsequent operation of the combination of this type of sensor and the control device (42).

## Revendications

1. Dispositif de commande (42) qui est conçu pour être utilisé dans un véhicule automobile tout en traitant des signaux de capteur et pour générer à partir de ceci des grandeurs réglantes par l'intermédiaire desquelles des actionneurs du véhicule automobile peuvent être commandés afin d'influer sur le comportement du véhicule automobile et/ou sur des éléments du véhicule automobile en fonctionnement, et qui présente au moins une entrée avec une borne d'entrée (12), au moins deux canaux d'entrée (20, 38) et un circuit d'entrée (43), et qui est conçu pour recevoir des signaux d'un capteur (10, 34) via la borne d'entrée (12) et pour faire entrer ceux-ci via le circuit d'entrée (43) dans un canal d'entrée (20, 38) de l'entrée, ladite borne d'entrée (12) étant connectée via une résistance à un potentiel défini, dans lequel le circuit d'entrée (43) comprend un premier interrupteur pull-up (44) qui est apte à être actionné par le dispositif de commande (42) et qui commande une connexion de la borne d'entrée (12) à un potentiel élevé, ainsi qu'un deuxième interrupteur pull-down (46) qui est apte à être actionné par le dispositif de commande (42) et qui commande une connexion de la borne d'entrée (12) à un potentiel bas, **caractérisé par le fait que** le dispositif de commande est conçu pour fermer l'interrupteur pull-down (46) et pour ouvrir l'interrupteur pull-up (44) et pour vérifier si une tension continue constante U est appliquée à un canal d'entrée (20), dont la valeur se situe dans une plage autorisée Uu < U < Uo, et, puis, si cela est le cas, pour stocker **le fait qu'**un capteur analogique (10) est connecté à la borne d'entrée (12), et pour sélectionner des structures logicielles adaptées pour l'évaluation ultérieure des signaux de capteur du capteur analogique (10) et/ou pour désactiver le trajet de courant pull-down en ouvrant l'interrupteur pull-down (46) et pour activer le trajet de courant pull-up en fermant l'interrupteur pull-up (44) et pour vérifier si, au niveau de la borne d'entrée (12), un signal est appliqué qui a une fréquence qui est comprise entre un seuil de fréquence inférieur fu et un seuil de fréquence supérieur fo et qui est plausible pour un capteur MLI, et, puis, si cela est le cas, pour stocker **le fait qu'**un capteur MLI (34) est connecté à la borne d'entrée (12), et pour sélectionner des structures logicielles adaptées à une évaluation des signaux d'un tel capteur MLI (34) pour le fonctionnement ultérieur de la combinaison de ce type de capteur et du dispositif de commande (42).

2. Dispositif de commande (42) selon la revendication 1, **caractérisé par le fait que** le dispositif de commande (42) est conçu pour faire commander l'interrupteur pull-up (44) par un propre port numérique (48) commandé par le micro-ordinateur (24), et pour faire commander l'interrupteur pull-down (46) via un propre port numérique (50) à partir du micro-ordinateur (24).

3. Dispositif de commande (42) selon la revendication 2, **caractérisé par le fait que** le dispositif de commande (42) est conçu pour, lorsque l'un des deux interrupteurs (44, 46) est fermé, ouvrir l'autre interrupteur respectif.

4. Dispositif de commande (42) selon la revendication 1, **caractérisé par le fait que** les deux interrupteurs (44) et (46) sont des transistors à effet de champ complémentaires ou des transistors bipolaires complémentaires et que le dispositif de commande (42) est conçu pour commander les deux interrupteurs via un même et seul port.

5. Dispositif de commande (42) selon l'une quelconque des revendications précédentes, **caractérisé par le fait que** l'interrupteur pull-up (44) est monté en série avec la résistance pull-up (36) et que l'interrupteur pull-down (46) est monté en série avec la résistance pull-down (26).

6. Dispositif de commande (42) selon l'une quelconque des revendications précédentes, **caractérisé par le fait que** le circuit d'entrée (43) relie à la borne d'entrée (12) aussi bien un canal d'entrée analogique (20) qu'un canal d'entrée numérique (38) d'une zone centrale (16) du dispositif de commande (42).

7. Dispositif de commande (42) selon l'une quelconque des revendications précédentes, **caractérisé par le fait que** l'interrupteur pull-up (44) et l'interrupteur pull-down (46) sont réalisés par des commutateurs high side et des commutateurs low side qui existent de toute façon dans un port numérique.

8. Procédé destiné à adapter un dispositif de commande (42) à un capteur (10, 34) à connecter au dispositif de commande (42), dans lequel ledit dispositif de commande (42) est conçu pour être utilisé dans un véhicule automobile tout en traitant des signaux de capteur et pour générer à partir de ceci des grandeurs réglantes par l'intermédiaire desquelles des actionneurs du véhicule automobile peuvent être commandés afin d'influer sur le comportement du véhicule automobile et/ou sur des éléments du véhicule automobile en fonctionnement, et qui présente au moins une entrée avec une borne d'entrée (12), au moins deux canaux d'entrée (20, 38) et un circuit d'entrée (43), et qui est conçu pour recevoir des signaux du capteur (10, 34) via la borne d'entrée (12) et pour faire entrer ceux-ci via le circuit d'entrée (43) dans un canal d'entrée (20, 38) de l'entrée, dans lequel l'adaptation comprend l'étape consistant à connecter ladite borne d'entrée (12) via une résistance à un potentiel défini, dans lequel la connexion de la borne d'entrée (12) réalisée par une résistance se fait par un premier interrupteur pull-up (44) qui est apte à être actionné par le dispositif de commande (42) et qui commande une connexion de la borne d'entrée (12) à un potentiel élevé, ou que la connexion se fait par un deuxième interrupteur pull-down (46) qui est apte à être actionné par le dispositif de commande (42) et qui commande une connexion de la borne d'entrée (12) à un potentiel bas, **caractérisé par le fait que** l'interrupteur pull-down (46) est fermé et l'interrupteur pull-up (44) est ouvert et qu'il est vérifié si une tension continue constante U est appliquée à un canal d'entrée (20), dont la valeur se situe dans une plage autorisée Uu < U < Uo, et que, puis, si cela est le cas, on stocke **le fait qu'**un capteur analogique (10) est connecté à la borne d'entrée (12), et que l'on sélectionne des structures logicielles adaptées pour l'évaluation ultérieure des signaux de capteur du capteur analogique (10) et/ou que l'on désactive le trajet de courant pull-down en ouvrant l'interrupteur pull-down (46) et on active le trajet de courant pull-up en fermant l'interrupteur pull-up (44), et qu'il est vérifié si, au niveau de la borne d'entrée (12), un signal est appliqué qui a une fréquence qui est comprise entre un seuil de fréquence inférieur fu et un seuil de fréquence supérieur fo et qui est plausible pour un capteur MLI, et que, puis, si cela est le cas, on stocke **le fait qu'**un capteur MLI (34) est connecté à la borne d'entrée (12), et que l'on sélectionne des structures logicielles adaptées à une évaluation des signaux d'un tel capteur MLI (34) pour le fonctionnement ultérieur de la combinaison de ce type de capteur et du dispositif de commande (42).
